# EUROPEAN PATENT SPECIFICATION

(11) **EP 3 907 831 B1**
(45) Date of publication and mention of the grant of the patent: **14.02.2024**
(21) Application number: 20305448.1
(22) Date of filing: 06.05.2020
(51) Int. Cl.: H01R 13/52, H01R 13/506

(54) **SEAL FOR AN ANGLED CONNECTOR**
DICHTUNG FÜR EINEN WINKELVERBINDER
JOINT POUR UN CONNECTEUR COUDÉ

(43) Date of publication of application: 10.11.2021
(73) Proprietor: Tyco Electronics France SAS, 95300 Pontoise (FR)
(72) Inventor: LORD, Steven, 95610 Eragny Sur Oise (FR); ROUILLARD, Xavier, 95130 Franconville La Garenne (FR)
(74) Representative: Grünecker Patent- und Rechtsanwälte PartG mbB

(56) References cited:
- CN-A- 104 505 604
- US-A1- 2005 112 912
- US-A1- 2007 224 881

## Description

The invention relates to a seal for an angled connector.

Angled connectors are used for a variety of applications, for example as squib connectors in airbags. In angled connectors a wire is inserted into a cavity of a connector housing in a first direction and a tip portion of the wire comprising a terminal is oriented in the cavity in a second direction angled to the first direction. Usually the connector housing comprises a base cover and a top cover mounted to each other enclosing the cavity. In order to protect the angled connector from contaminants such as liquids, which may cause a shortcut of the angled connector, it is essential to seal the connector. Both the interface between the top and bottom cover and the wire insertion into the cavity of the connector housing needs to be sealed.

US 2007/0224881 A1 relates to a waterproof electrical connector for electrically connecting wiring to a mating connector having a concavity, the waterproof electrical connector having a contact connected to an end of a wire, a housing having a fitting section configured to at least partially house the contact and configured for insertion into the concavity, a seal integrally arranged on an outer periphery surface near a top end of the fitting section, which sealingly contacts an inner wall of the concavity when the fitting section is inserted into the concavity, and a lock which prevents the housing from exiting the concavity once the fitting section has been inserted into concavity to a predetermined depth.

Therefore, it is the objective of the invention to provide an improved, reliable and cost-efficient seal for angled connectors.

This object is solved by the subject-matter of claim 1.

Preferred embodiments are defined by the dependent claims.

In accordance with the present invention, the problem is solved by a seal for an angled connector, the seal having an essentially planar plate-shaped configuration. The seal comprises a rim wall that encloses a central opening, wherein at least one sealing passage extends from outside the seal through the rim wall into the central opening, and wherein the seal is penetrated by the central opening.

The wire may enter the central opening through the sealing passage so that the sealing passage may seal a wire insertion part of the connector housing. In the central opening, the tip portion of the wire may be bent in the desired direction, so that the tip portion of the wire is arranged at an angle to the remainder of the wire, particularly the part of the wire arranged in the sealing passage. The rim wall on the other hand may press against the inner wall of the connector housing thereby providing an interface seal between the top and bottom cover of the housing. With the seal having an essentially planar plate-shaped configuration the seal may be uniformly compressed within the cavity of the connector housing without having any transition areas caused by steps or the like in the seal, which may negatively affect the sealing performance of the seal.

The invention can be further improved by the following features, which are independent from one another with regard to their respective technical effects and which can be combined arbitrarily.

For example, according to the first aspect of the invention, the at least one sealing passage may extend continuously from outside the seal through the rim wall into the central opening. Therefore, no transition area is provided between the at least one sealing passage and the central opening, and the rim wall may thus be evenly compressed between the top cover and bottom cover at the portion of the seal at which the at least one sealing passage is provided. Hence, the sealing performance of the seal may be further improved.

Preferably, the entire rim wall may be planar. Particularly the rim wall may comprise an essentially planar top and/or bottom surface, which may be arranged essentially parallel to the central opening. The entire top and/or bottom surface may extend in a single plane, respectively. If both the top and the bottom surface each extend in a single plane, the single planes may be spaced apart from one another in an axial direction. The single planes may be arranged essentially parallel to one another, so that the entire rim wall may comprise an essentially constant axial thickness.

The at least one sealing passage may be formed as a through-opening extending radially through the rim wall. Thus, the at least one sealing passage may comprise a diameter less than a material thickness, particularly the axial direction, of the rim wall.

For improving the sealing of the wire in the sealing passage, an inner wall of the sealing passage may preferably comprise an undulating shape, such as a so-called "sine"-waveform having peaks that protrude into the sealing passage and indentations between two adjacent peaks. The peaks of the undulating shape may be compressed, ensuring a reliable sealing between the wire and the connector. When the peaks are compressed, material may be deflected into the indentations between two adjacent peaks. Thus, the undulating shape of the inner wall of the sealing passage may also lead to a tolerance in wire size, so that the sealing passage may be adapted to seal a wire within a predetermined wire range.

The at least one sealing passage may be adapted to receive a terminal of the wire, such that the wire may be inserted into the central opening through the sealing passage after it has been terminated, e.g. by crimping or welding. The terminal end portion usually comprises a larger diameter than the remainder of the wire. Therefore, the inner wall of the sealing passage may be adapted to be elastically deflected, so that the terminal may pass through the sealing passage. An elastic seal having good sealing properties may, for example, comprise a silicone material. The seal may comprise at least one compression rib protruding from at least one of the bottom and top surface of the rim wall. The at least one compression rib may be pressed against the bottom cover or the top cover, respectively, and thus further improve the sealing performance of the seal.

The at least one compression rib may be arranged symmetrically on the rim wall, meaning that the material thickness of the rim wall in the radial direction, radially inwardly from the at least one compression rib and radially outwardly from the at least one compression rib may be essentially the same.

Preferably, the shape of the at least one compression rib may extend around a circumference of the rim wall on the top and/or bottom surface mimicking the outer contour of the seal.

In an advantageous embodiment, the outer shape of the seal, particularly the rim wall and the outer shape of the central opening, may be essentially the same. Hence, the uniformity of the axial compression between the bottom cover and the top cover may be further improved, further enhancing the sealing performance of the interface seal.

The central opening penetrates the seal in the axial direction, allowing access to the termination end of the wire inserted via the sealing passage into the central opening from either axial direction.

The interface seal provided by the rim wall may be formed by a radial compression of the rim wall and the housing. To further increase the radial compression, the seal may comprise at least one radially outwardly protruding sealing lip. The at least one radially outwardly protruding sealing lip may be protrude from a radially outwards facing side surface of the rim wall. A radial interface seal formed by the at least one sealing lip may reduce the permanent constraints acting upon the cover in comparison to an axial seal. Thus, the axial compression of the seal within the housing can be lowered or even evaded, so that the durability of the angled connector can be increased. Preferably, the at least one sealing lip may circumferentially extend around the seal, particularly the side surface of the rim wall, allowing a uniform radial compression of the sealing lip throughout the radial interface between the seal and the connector housing.

According to a further advantageous embodiment, at least two radially protruding sealing lips may be provided, wherein one sealing lip may be arranged at a top half of the side surface of the rim wall closer to the top surface in the axial direction, and the other of the at least two sealing lips may be arranged on a bottom half of the side surface of the rim wall closer to the bottom surface in the axial direction. Therefore, the sealing lips may be configured to provide a radial seal for different housing parts, i.e. the top cover and bottom cover, of the connector housing.

The seal, particularly the rim wall may comprise an essentially U-shaped arc section, having two arms extending parallel to one another connected to one another by a bow. The ends of the two arms remote from the bow may be connected to one another by a straight base.

The at least one base may comprise a larger radial thickness than the arc section, wherein the at least one sealing passage may preferably extend through the base. Thus, the interface area between the sealing passage and the wire may be increased. Furthermore, the base may be rather rigid compared to the U-shaped arc section, therefore preventing any damage to the wire in the sealing passage due to unintentional deformation of the base.

In a preferred exemplary embodiment, the seal may comprise at least two sealing passages each for sealing a different wire. Thus, the seal may act as a family seal allowing the introduction of multiple wires into the central opening. For each wire, a separate sealing passage may be provided.

Preferably, the at least two sealing passages may extend parallel to one another.

According to a further aspect of the invention an angled connector may be provided, the connector comprising a bottom cover and a top cover mountable to one another, the bottom cover and top cover enclosing a cavity, wherein an inventive seal according to any of the above embodiments may be inserted into the cavity sealingly engaging the bottom cover and the top cover.

The angled connector may particularly be a squib connector. The squib connector may be, for example, used in a safety application in vehicles such as airbag or seatbelt pre-tensioning systems. In an airbag system, the squib connector may be adapted to connect a main wiring of the airbag to an inflator.

The seal may be axially compressed between the top cover and the bottom cover, so that the top surface of the seal is pressed against a face of the top cover and the bottom surface of the seal is pressed against a face of the bottom cover.

Preferably, at least one compression rib may be formed on the top surface and the bottom surface of the seal. Alternatively, the face of the top cover and the face of the bottom cover facing the top surface and the bottom surface, respectively, may feature at least one compression rib.

An interface seal via axial compression between the covers and the seal may allow for a simple manufacturing of the seal and less radial space requirements of the seal within the cavity. However, as the axial compression may produce a permanent strain on the covers, a radial interface seal may be additionally or alternatively provided, e.g. via the sealing lips.

At least one of the top cover and bottom cover may comprise a support structure extending from the face into the cavity, wherein the support structure is fittingly received in the central opening. Therefore, the support structure may prevent any deformation of the rim walls inside the cavity and thus secure the seal within the cavity.

In the following, the seal according to the invention is explained in greater detail with reference to the accompanying drawings, in which exemplary embodiments are shown.

In the figures, the same reference numerals are used for elements which correspond to one another in terms of their function and/or structure.

According to the description of the various aspects and embodiments, elements shown in the drawings can be omitted if the technical effects of these elements are not needed for a particular application, and *vice versa:* i.e. elements that are not shown or described with reference to the figures but are described above can be added if the technical effect of those particular elements is advantageous in a specific application.

In the figures:
- Fig. 1: shows a schematic perspective view of a first exemplary embodiment of the inventive seal;
- Fig. 2: shows a schematic perspective view of a second exemplary embodiment of the inventive seal;
- Fig. 3: shows a schematic perspective view of a third exemplary embodiment of the inventive seal;
- Fig. 4: shows a schematic perspective view of an exemplary embodiment of an angled connector with the second embodiment of the inventive seal; and
- Fig. 5: shows a schematic cut view of an exemplary embodiment of the angled connector with the third embodiment of the inventive seal.

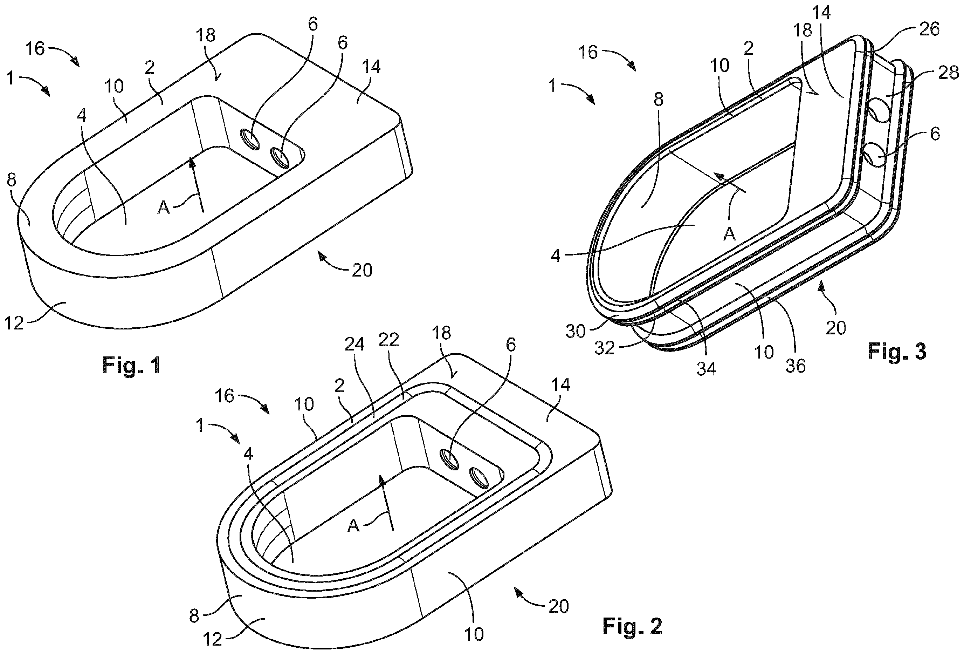

First, exemplary embodiments of an inventive seal 1 are described with reference to Figs. 1 to 3. The seal 1 according to the invention may be adapted for an angled connector, wherein the seal has an essentially planar plate-shaped configuration. The seal 1 comprises a rim wall 2 that encloses a central opening 4, whereby at least one sealing passage 6 extends from outside the seal 1 through the rim wall 2 into the central opening 4.

Consequently, a wire may be sealingly received in the sealing passage 6 and be introduced into the central opening 4, at which a tip portion of the wire may be bent, so that the tip portion may be arranged at an angle, particularly at a 90° angle, to the remainder of the wire, particularly the section of the wire received in the sealing passage 6.

The seal 1 may be a single wire seal having only one sealing passage 6 for a single wire. However, more preferably the seal may be a family seal having multiple sealing passages 6, each adapted to sealingly receive a single wire. In the embodiments shown in Figs. 1 to 3 two sealing passages 6 are provided. Of course it is also possible to provide more than two sealing passages 6 according to the application requirements.

The central opening 4 penetrates the seal 1 in an axial direction A, allowing access to the wire inserted into the central opening 4 via the sealing passage 6 to be accessible from either side in the axial direction A.

The seal 1, particularly the rim wall 2, may comprise an essentially U-shaped arc section 8, having two arms 10 extending parallel to one another and a bow 12 connecting the two arms 10 remote from the sealing passage 6. The ends of the arms 10 distal from the bow 12 may be connected to one another with an essentially straight base 14. The base 14 may comprise a larger material thickness in a radial direction than the arc section 8. The sealing passage 6 may preferably extend essentially parallel to a radial direction through the base 14, the radial direction being arranged essentially perpendicular to the axial direction A. Thus, the sealing interface between the sealing passage 6 and the wire may be increased.

As can be seen in Figs. 1 to 3, when at least two sealing passages 6 are provided, the at least two sealing passages 6 may preferably extend parallel to one another radially through the base 14.

In order to facilitate the handling of the seal 1 and further reduce the manufacturing costs of the seal 1 particularly in large numbers, the seal 1 may be a monolithic component 16, which may be formed for example by injection moulding. The seal 1 may preferably comprise a silicone material.

The sealing passages 6 may preferably extend continuously from outside the seal 1 through the rim wall 2 into the central opening 4, so that no transition area between the central opening and the rim wall is provided, which may negatively affect the sealing performance of the seal 1. The central opening 1 may particularly be a single, continuous opening which is not separated into different subsections.

To further improve the sealing reliability of the seal 1 the entire rim wall 2 may be arranged in a plane. The entire rim wall 2 may comprise an essentially planar top surface 18 and an essentially planar bottom surface 20. Preferably, the seal 1 may preferably be symmetrical along a plane essentially perpendicular to the axial direction A, such that the seal 1 may be inserted into the cavity in at least two different orientations without negatively affecting the sealing performance. Thus, the seal 1 can be further fool proved. It is noted that the terms "top" and "bottom" are solely used for distinguishing the opposing surfaces of the seal 1, whereby one surface is directed parallel to the axial direction to a first cover part and the other surface is directed towards a further cover part, i.e. the top and bottom cover, respectively.

In a further preferable configuration the entire rim wall 2 may have a constant thickness in the axial direction A, so that the top cover and the bottom cover of the connector may evenly axially compress the seal 1, as can be seen in Figs. 1 to 3.

Particularly the axial thickness of the rim wall at the arc section may be larger than the diameter of the sealing passage 6 so that the axial thickness of the base 14 does not have to be increased relative to the arc section 8. Consequently, no transition areas are formed, e.g. due to steps formed on the top and bottom surfaces from the arc section to the base.

As can be seen in Figs. 1 to 3, the outer shape of the seal 1, particularly the rim wall 2 and the shape of the central opening 4 in a plane essentially perpendicular to the axial direction A may be essentially the same. Preferably, the arc section 8, whose curvature may define the shape of both the outer shape of the seal 1 and the shape of the central opening 4 may comprise an essentially constant material thickness, at least in the radial direction. Thus, it may be ensured that the sealing proficiency along the arc section 8 is essentially uniform.

According to the exemplary embodiment shown in Fig. 2, at least one of the bottom surface 20 and the top surface 18, preferably both, may comprise at least one compression rib 22 protruding axially from the respective surface.

The at least one compression rib 22 may be adapted to press in the axial direction A against the top cover or bottom cover, respectively, whereby due to the axial compression of the at least one compression rib 22 the sealing performance of the seal 1 may be further increased.

In order to have an essentially uniform compression, the at least one compression rib 22 may extend on the top 18 and/or bottom surface 20 circumferentially along the entire rim wall. In other words, the at least one compression rib 22 may extend along the base 14 and the arc section 8 forming a collar 24 protruding axially from the respective surface 20.

The at least one compression rib 22 may extend continuously, meaning that the at least one compression rib 22 does not comprise any interruptions. Of course, it is also possible to provide multiple separate compression ribs separated from one another, e.g. in a radial direction or in a circumferential direction on the respective surface. However, this may lead to an uneven compression of the seal and thus would lead to a deterioration of the sealing performance.

Alternatively or additionally, the at least one compression rib 22 may be provided on a face side of the top cover and/or bottom cover facing the top surface 18 and bottom surface 20 of the rim wall 4, respectively. In this case, the at least one compression rib 22 presses into the corresponding surface of the seal 1. The top surface 18 and/or bottom surface 20 may be essentially flat having no axial protrusions, as is shown in the first embodiment of the seal 1 depicted in Fig. 1.

Preferably, the at least one compression rib may be arranged equidistantly in the radial direction on the top and/or bottom surface. In other words, the material thickness of the rim wall 2 from the at least one compression rib 22 radially inwardly and outwardly may be essentially the same.

Usually the top cover and the bottom cover of the angled connector are mounted to one another in the axial direction A. In this case, the axial compression of the seal 1 between the top cover and the bottom cover may lead to a permanent constraint on the covers as the compression of the seal 1 may produce a counterforce acting upon the covers pushing them in the axial direction A away from one another.

In order to reduce the axial compression A without negatively affecting the sealing performance, a radial compression of the seal 1 may be envisaged.

This may, for example, be enforced by at least one radially outwardly protruding sealing lip 26, as is shown in the exemplary embodiment displayed in Fig. 3.

The at least one sealing lip 26 may protrude radially outwardly from a side surface 28 of the rim wall 2 facing radially outwards, i.e. away from the central opening 4. Preferably, the at least one sealing lip 26 may extend, particularly continuously, along the circumference of the seal 1, ensuring a uniform radial compression of the seal 1 along it's whole circumference.

In order for the at least one sealing passage 6 not to interfere with the at least one sealing lip 26, the at least one sealing lip 26 and the at least one sealing passage 6 may be offset from one another essentially parallel to the axial direction A.

As can be seen in Fig. 3, a pair of sealing lips 6 may be arranged adjoining one another in the axial direction A, each lip having a radially outwardly protruding protrusion 30 and a notch 32 formed between the pair of protrusions 30. Therefore, a higher load of contact between the seal 1 and the connector housing in the radial direction can be achieved.

Preferably, at least one sealing lip 26 may be provided at a top edge 34 of the side surface 28 bordering the top surface 18, and at least one sealing lip 26 may be provided at a bottom edge 36 bordering the bottom surface 20 of the rim wall 2. The at least one sealing lip 26 at the top edge 34 may be adapted to sealingly engage the top cover of the connector housing. Correspondingly, the sealing lip 26 at the bottom edge 36 may be adapted to sealingly engage the bottom cover of the connector housing.

The top edge 34 and the bottom edge 36 may be separated from one another essentially parallel to the axial direction A by a middle section 38, through which the at least one sealing passage 6 may extend essentially parallel to the radial direction.

As can be seen in Fig. 3, a pair of sealing lips 26 may be provided at the top and at the bottom edge of the side surface 28.

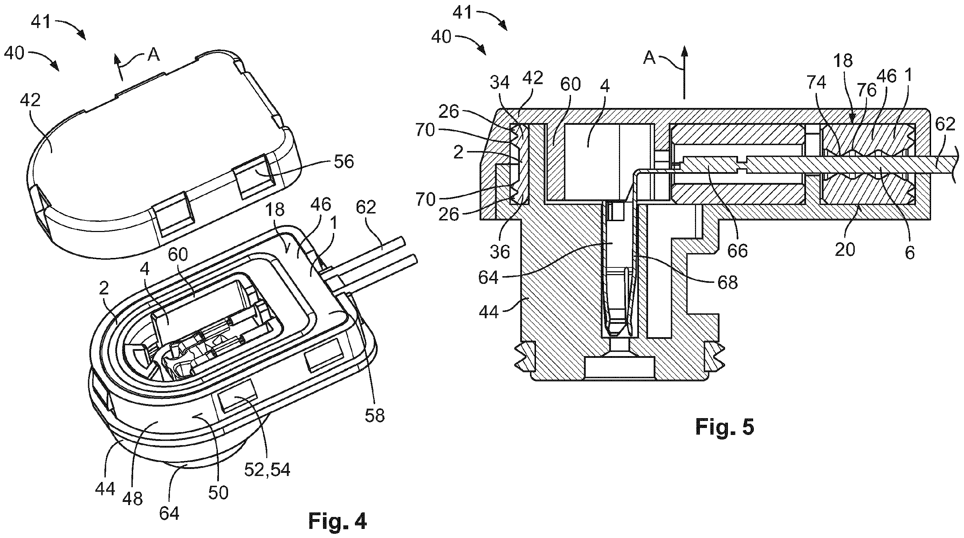

Now exemplary embodiments of angled connectors 40 are further elucidated with reference to Figs. 4 and 5.

The angled connector 40 may be a squib connector adapted for use in safety systems in vehicles, particularly in airbag systems.

The angled connector 40 may comprise a connector housing 41 having a top cover 42 and a bottom cover 44 being mountable to one another, whereby the top cover 42 and the bottom cover 44 may enclose a cavity 46 when the covers are mounted to each other. The seal 1 may be inserted into the cavity 46, whereby the seal 1 is adapted to sealingly engage the top cover 42 and the bottom cover 44.

In Fig. 4 a schematic perspective view of a first exemplary embodiment is shown, whereby the top cover 42 is removed from the bottom cover 44 allowing visual access to the cavity 46 and the seal 1 mounted in the cavity 46.

In this embodiment, the seal 1 according to Fig. 2 is inserted into the cavity, such that the bottom surface 20 of the rim wall 2 lies on a face side of the bottom cover 44 and the top surface 18 is adapted to abut a face side of the top cover 44, the face sides facing towards the cavity 46.

The bottom cover 44 may comprise an axially protruding frame 48, whose radially outwards facing surface 50 may comprise fastening means 52, such as latches 54, which may engage complementarily formed fastening means 56 of the top cover 42 in a form-locking manner. The frame 48 may frame a compartment 58 in the bottom cover 44 in which the seal 1 may be fittingly received, whereby the frame 48 comprises an opening being aligned with a corresponding sealing passage 6 of the seal, in order to allow the wire to enter the cavity from outside the connector.

Furthermore, the bottom cover 44 may comprise a support structure 60 fittingly inserted into the central opening 4 so as to provide a fortification for the rim wall 2, particularly the arc section 8.

When the top cover 42 is mounted to the bottom cover 44 essentially parallel to the axial direction A, an axial compression force acts on the seal 1 compressing the seal 1 parallel to the axial direction A between the top cover and the bottom cover.

A wire 62 may be inserted into the housing and through the sealing passage 6. Thus, the wire 62 may be sealingly inserted into the connector housing comprising the top cover and bottom cover mounted to one another. Preferably, the wire 62 may extend from the sealing passage 6 through the support structure into an extension 64 of the bottom cover, which extends in a direction arranged in an angle to a radial plane. In this case, the angled connector 40 may be a 90° angled connector, so that the extension 64 may extend essentially parallel to the axial direction A away from the top cover 42. A tip portion 66 of the wire 62 may particularly terminated onto a terminal 68, which may extend essentially parallel to the extension 64 into the extension 64, e.g. coaxially to the extension 64.

In Fig. 5 a second exemplary embodiment of the angled connector 40 is shown in a schematic cut view cut along a plane essentially parallel to the axial direction A.

In the second embodiment, a seal 1 according to Fig. 3 is inserted into the cavity 46 such that the sealing lips 26 at the top edge 34 are radially pressed against a side wall 70 of the top cover 42 and the sealing lips 26 at the bottom edge 32 are radially pressed against a side wall 70 of the bottom cover 44. Therefore, the seal 1 may radially, hermetically seal the top cover 42 and bottom cover 44.

The seal 1 and the connector housing 41 comprising the top cover 42 and the bottom cover 44 may be separate parts being removable from one another, so that the seal 1 may easily be replaced in the case of any malfunctions.

Fig. 5 allows a view of the at least one sealing passage 6. The sealing passage 6 may be adapted to sealingly receive the wire 62, such that fluid, particularly liquid is not able to enter the angled connector via a wire entrance.

In order to increase the amount of contact points and further stabilize the wire 62 in the sealing passage 6, an inner wall 72 of the sealing passage may comprise an essentially undulating shape having peaks 74 protruding into the sealing passage 6 and indentations 76 between two adjacent peaks 74 in the radial direction.

The indentations 76 provide space for the material of the peaks 74 to disperse into, when being compressed. Therefore, a play may be provided allowing wires within a predetermined range of wire diameters to be sealingly received in the sealing passage 6. The at least one sealing passage 6 may be adapted to receive the terminal 68 so that the wire 62 may be terminated prior to insertion into the sealing passage 6.

### Reference numerals

- 1: seal
- 2: rim wall
- 4: central opening
- 6: sealing passage
- 8: arc section
- 10: arm
- 12: bow
- 14: base
- 16: monolithic component
- 18: top surface
- 20: bottom surface
- 22: compression rib
- 24: collar
- 26: sealing lip
- 28: side surface
- 30: protrusion
- 32: notch
- 34: top edge
- 36: bottom edge
- 38: middle section
- 40: angled connector
- 41: connector housing
- 42: top cover
- 44: bottom cover
- 46: cavity
- 48: frame
- 50: radially outwardly facing surface
- 52: fastening means
- 54: latches
- 56: complementary formed fastening means
- 58: compartment
- 60: support structure
- 62: wire
- 64: extension
- 66: tip portion
- 68: terminal
- 70: side wall
- 72: inner wall
- 74: peak
- 76: indentation
- A: axial direction

## Claims

1. Seal (1) for an angled connector (40), the seal (1) having a planar plate-shaped configuration and the seal (1) having a rim wall (2) that encloses a central opening (4), wherein at least one sealing passage (6) extends from outside the seal (1) through the rim wall (2) into the central opening (4), **characterized in that** the seal (1) is penetrated by the central opening (4) in an axial direction, allowing a wire, to be inserted into the central opening (4) via the sealing passage (6), to be accessible from either side in said axial direction.

2. Seal (1) according to claim 1, wherein the at least one sealing passage (6) extends continuously from outside the seal (1) into the central opening (4).

3. Seal (1) according to claim 1 or 2, wherein the entire rim wall (2) is planar.

4. Seal (1) according to any one of claims 1 to 3, wherein the rim wall (2) comprises at least one of a planar top surface (18) and a planar bottom surface (20) extending in a plane essentially parallel to the central opening (4).

5. Seal (1) according to claim 4, wherein at least one compression rib (22) protrudes from at least one of the top surface (18) and the bottom surface (20).

6. Seal (1) according to claim 5, wherein the at least one compression rib (22) continuously extends along a closed perimeter.

7. Seal (1) according to any one of claims 1 to 6, wherein the seal (1) comprises at least one radially outwardly protruding sealing lip (26).

8. Seal (1) according to claim 7, wherein the at least one sealing lip (26) extends circumferentially around the seal (1).

9. Seal (1) according to claim 7 or claim 8, wherein at least two sealing lips (26) are provided, the at least two sealing lips (26) being arranged on two axially opposite ends of a radially outwardly facing side surface (28) of the rim wall (2).

10. Seal according to any one of claims 1 to 9, wherein the seal (1) comprises an essentially U-shaped arc section (8) having two arms (10) extending parallel to one another and a bow (12) connecting the arms (10) and wherein ends of the arms (10) remote from the bow (12) are connected to one another by a straight base (14).

11. Seal (1) according to claim 10, wherein the at least one sealing passage (6) radially extends from outside the seal (1) through the base (14) into the central opening (4).

12. Seal (1) according to claim 10 or 11, wherein the base (14) comprises a larger radial thickness than the arc section (8).

13. Seal (1) according to any one of claims 1 to 12, wherein at least two sealing passages (6) are provided, the at least two sealing passages (6) being arranged parallel to one another.

14. Seal (1) according to any one of claims 1 to 12, wherein an inner wall (72) of the at least one sealing passage (6) comprises an undulating shape with peaks (74) protruding into the sealing passage (6) and indentations (76) arranged between two adjacent peaks (74).

15. Angled connector (40) comprising a top cover (42) and a bottom cover (44) mounted to one another and enclosing a cavity (46), wherein a seal (1) according to any one of claims 1 to 14 is held in the cavity (46) sealingly engaging the top cover (42) and the bottom cover (44).

## Patentansprüche

1. Dichtung (1) für einen abgewinkelten Verbinder (40), wobei die Dichtung (1) einen planen, plattenförmigen Aufbau hat und die Dichtung (1) eine Einfassungswand (2) aufweist, die eine mittige Öffnung (4) umschließt, sich wenigstens ein Dichtungsdurchlass (6) von außerhalb der Dichtung (1) durch die Einfassungswand (2) hindurch in die mittige Öffnung (4) hinein erstreckt, **dadurch gekennzeichnet, dass** die mittige Öffnung (4) in einer axialen Richtung durch die Dichtung (1) hindurch verläuft, so dass ein Draht, der über den Dichtungsdurchlass (6) in die mittige Öffnung (4) eingeführt werden soll, von beiden Seiten in der axialen Richtung zugänglich ist.

2. Dichtung (1) nach Anspruch 1, wobei sich der wenigstens eine Dichtungsdurchlass (6) durchgehend von außerhalb der Dichtung (1) in die mittige Öffnung (4) hinein erstreckt.

3. Dichtung (1) nach Anspruch 1 oder 2, wobei die gesamte Einfassungswand (2) plan ist.

4. Dichtung nach einem der Ansprüche 1 bis 3, wobei die Einfassungswand (2) eine plane obere Fläche (18) oder/und eine plane untere Fläche (20) umfasst, die sich in einer Ebene im Wesentlichen parallel zu der mittigen Öffnung (4) erstreckt/erstrecken.

5. Dichtung (1) nach Anspruch 4, wobei wenigstens eine Kompressionsrippe (22) von der oberen Fläche (18) oder/und der unteren Fläche (20) vorsteht.

6. Dichtung (1) nach Anspruch 5, wobei sich die wenigstens eine Kompressionsrippe (22) durchgehend entlang eines geschlossenen Umfangs erstreckt.

7. Dichtung (1) nach einem der Ansprüche 1 bis 6, wobei die Dichtung (1) wenigstens eine radial nach außen vorstehende Dichtlippe (26) umfasst.

8. Dichtung (1) nach Anspruch 7, wobei sich die wenigstens eine Dichtlippe (26) in Umfangsrichtung um die Dichtung (1) herum erstreckt.

9. Dichtung (1) nach Anspruch 7 oder Anspruch 8, wobei wenigstens zwei Dichtlippen (26) vorhanden sind, und die wenigstens zwei Dichtlippen (26) an zwei axial gegenüberliegenden Enden einer radial nach außen gerichteten Seitenfläche (28) der Einfassungswand (2) angeordnet sind.

10. Dichtung nach einem der Ansprüche 1 bis 9, wobei die Dichtung (1) ein im Wesentlichen U-förmiges Bogenprofil (8) mit zwei sich parallel zueinander erstreckenden Schenkeln (10) sowie einem die Schenkel (10) verbindenden Bogen (12) umfasst und von dem Bogen (12) entfernte Enden der Schenkel (10) über eine gerade Basis (14) miteinander verbunden sind.

11. Dichtung (1) nach Anspruch 10, wobei sich der wenigstens eine Dichtungsdurchlass (6) radial von außerhalb der Dichtung (1) durch die Basis (14) hindurch in die mittige Öffnung (4) hinein erstreckt.

12. Dichtung (1) nach Anspruch 10 oder 11, wobei die Basis (14) eine größere radiale Dicke hat als das Bogenprofil (8).

13. Dichtung (1) nach einem der Ansprüche 1 bis 12, wobei wenigstens zwei Dichtungsdurchlässe (6) vorhanden sind und die wenigstens in Dichtungsdurchlässe (6) parallel zueinander angeordnet sind.

14. Dichtung (1) nach einem der Ansprüche 1 bis 12, wobei eine Innenwand (72) des wenigstens einen Dichtungsdurchlasses (6) eine Wellenform mit in den Dichtungsdurchlass (6) hineinragenden Erhebungen (74) und zwischen zwei benachbarten Erhebungen (74) angeordneten Vertiefungen (76) umfasst.

15. Abgewinkelter Verbinder (40), der eine obere Abdeckung (42) sowie eine untere Abdeckung (44) umfasst, die aneinander angebracht sind und einen Hohlraum (46) umschließen, wobei eine Dichtung (1) nach einem der Ansprüche 1 bis 14 in dem Hohlraum (46) aufgenommen ist und abdichtend mit der oberen Abdeckung (42) und der unteren Abdeckung (44) in Eingriff ist.

## Revendications

1. Joint (1) pour un connecteur coudé (40), le joint (1) présentant une configuration en forme de plaque planaire et le joint (1) présentant une paroi de bord (2) qui entoure une ouverture centrale (4), dans lequel au moins un passage d'étanchéité (6) s'étend depuis l'extérieur du joint (1) à travers la paroi de bord (2) dans l'ouverture centrale (4), **caractérisé en ce que** le joint (1) est pénétré par l'ouverture centrale (4) dans une direction axiale, permettant à un fil d'être inséré dans l'ouverture centrale (4) via le passage d'étanchéité (6), pour être accessible depuis chaque côté dans ladite direction axiale.

2. Le joint (1) selon la revendication 1, dans lequel l'au moins un passage d'étanchéité (6) s'étend de manière continue depuis l'extérieur du joint (1) dans l'ouverture centrale (4).

3. Le joint (1) selon la revendication 1 ou 2, dans lequel l'intégralité de la paroi de bord (2) est planaire.

4. Le joint (1) selon l'une quelconque des revendications 1 à 3, dans lequel la paroi de bord (2) comprend au moins une d'une surface de dessus planaire (18) et d'une surface de fond planaire (20) s'étendant dans un plan essentiellement parallèle à l'ouverture centrale (4).

5. Le joint (1) selon la revendication 4, dans lequel au moins une nervure de compression (22) déborde d'au moins une de la surface de dessus (18) et de la surface de fond (20).

6. Le joint (1) selon la revendication 5, dans lequel l'au moins une nervure de compression (22) s'étend de manière continue le long d'un périmètre fermé.

7. Le joint (1) selon l'une quelconque des revendications 1 à 6, dans lequel le joint (1) comprend au moins une lèvre d'étanchéité débordant radialement vers l'extérieur (26).

8. Le joint (1) selon la revendication 7, dans lequel l'au moins une nervure de compression (26) s'étend de manière circonférentielle autour du joint (1).

9. Le joint (1) selon la revendication 7 ou la revendication 8, dans lequel au moins deux lèvres d'étanchéité (26) sont disposées, les aux moins deux lèvres d'étanchéité (26) étant disposées sur deux extrémités axialement opposées d'une surface latérale radialement orientée vers l'extérieur (28) de la paroi de bord (2).

10. Le joint selon l'une quelconque des revendications 1 à 9, dans lequel le joint (1) comprend une section en arc essentiellement en forme de U (8) présentant deux bras (10) s'étendant parallèles l'un à l'autre et une courbure (12) connectant les bras (10), et dans lequel des extrémités des bras (10) éloignées de la courbure (12) sont connectées l'une à l'autre par une base droite (14) .

11. Le joint (1) selon la revendication 10, dans lequel l'au moins un passage d'étanchéité (6) s'étend radialement depuis l'extérieur du joint (1) à travers la base (14) dans l'ouverture centrale (4).

12. Le joint (1) selon la revendication 10 ou 11, dans lequel la base (14) comprend une épaisseur radiale plus importante que la section en arc (8).

13. Le joint (1) selon l'une quelconque des revendications 1 à 12, dans lequel au moins deux passages d'étanchéité (6) sont disposés, les au moins deux passages d'étanchéité (6) étant disposés parallèles l'un à l'autre.

14. Le joint (1) selon l'une quelconque des revendications 1 à 12, dans lequel une paroi interne (72) de l'au moins un passage d'étanchéité (6) comprend une forme ondulatoire avec des pics (74) débordant dans le passage d'étanchéité (6) et des indentations (76) disposées entre deux pics adjacents (74).

15. Connecteur coudé (40) comprenant un couvercle de dessus (42) et un couvercle de fond (44) montés l'un sur l'autre et abritant une cavité (46), dans lequel un joint (1) selon l'une quelconque des revendications 1 à 14 est maintenu dans la cavité (46) mettant en contact de manière étanche le couvercle de dessus (42) et le couvercle de fond (44).
